Europäisches Patentamt

European Patent Office

Office européen des brevets

(11) Publication number: **0 130 363**
**A2**

## EUROPEAN PATENT APPLICATION

(21) Application number: **84106065.0**

(22) Date of filing: **28.05.84**

(51) Int. Cl.⁴: **H 03 K 19/094**

(30) Priority: **27.06.83 US 508454**

(43) Date of publication of application: **09.01.85**
**Bulletin 85/2**

(84) Designated Contracting States: **DE FR GB**

(71) Applicant: **International Business Machines Corporation, Old Orchard Road, Armonk, N.Y. 10504 (US)**

(72) Inventor: **Davis, James William, 1385 S.W. 3rd Street, Boca Raton Florida 33431 (US)**
Inventor: **Thoma, Nandor Gyorgy, 4686 N.W. 2nd Court, Boca Raton Florida 33431 (US)**

(74) Representative: **Bonneau, Gérard, Compagnie IBM France Département de Propriété Industrielle, F-06610 La Gaude (FR)**

(54) Differential logic circuit implemented in complementary transistor technology.

(57) The differential logic circuit has first (1a) and second (2a) P channel load devices interconnected with first (31) and second (32) N channel NMOS differential logic networks each comprising a plurality of N channel devices (50–57, 60–67), the second N channel NMOS differential logic network being provided in lieu of a corresponding plurality of P channel devices.

DIFFERENTIAL CVSL EXAMPLES

BASED ON SINGLE-ENDED CVSL EXAMPLE

EP 0 130 363 A2

## DIFFERENTIAL LOGIC CIRCUIT
## IMPLEMENTED IN COMPLEMENTARY TRANSISTOR TECHNOLOGY

This invention relates generally to an enhancement to the complementary transistor technology and particularly to a differential logic circuit with efficient load characteristics..

The evolution of microelectronics has been discussed in many books and articles. For example, in the Scientific American book entitled "Microelectronics", published in 1977 by W. H. Freeman and Co. the book-publishing affiliate of Scientific American, a variety of individual articles address the nature of microelectronic elements, their design and fabrication particularly in the form of Large Scale Integrated Circuits, their applications, and their impact for the future.

The IBM Journal of Research and Development has had a number of articles from time to time concerning various microelectronics technologies of this nature which are included in the May 1981 issue: "VLSI Circuit Design", the May 1982 issue: "Packaging Technology" and the September 1982 issue: "Semiconductor Manufacturing Technology".

CMOS technologies are of special interest in the present patent application and contrasts with the Metal Oxide Semiconductor (MOS) technologies that are set forth in the Scientific American book in that both N channel and P channel devices are fabricated simultaneously. However, a number of other manufacturing techniques of basic interest are also described, in the Scientific American book. As one example, on page 42 thereof Large Scale Integrated circuits may be produced by computer control by proceeding through a number of steps including the use of optical techniques for generating topological patterns.

Other items of interest to microelectronics fabrication in particular, including master slice layout, logic cell layout and arrangements for achieving high density in such circuits include the following:

Technical Disclosure Bulletin article entitled "Cascode Decoder" by J. E. Gersbach and J. K. Shortle, published September 1965, Vol. 8, No. 4 at pp. 642-643 which concerns closely controlled input voltages, differentially connected to the inputs of a cascode decoder thereby providing high speed operation with minimum power dissipation.

Technical Disclosure Bulletin article entitled "Bipolar FET High-Speed Logic Switch" by R. D. Lane, published May 1972, Vol. 14, No. 12 at pp. 3684-3685 relating to the high speed operation of both positive and negative transitions at low power in a bipolar transistor current switch circuit by the provision of a pair of cross-connected field-effect transistor (FET) loads for the current switch bipolar transistors.

Technical Disclosure Bulletin article entitled "Generation of Mask Layout from Topological Equations" by B. Vergnieres published December 1980, Vol. 23, No. 7A, pp. 2833-2835 provides for the combination of manual design and automatic design automation which together provides the greatest flexibility, rapidity and density for manufactured integrated circuits.

Technical Disclosure Bulletin article entitled "Cascode Parity Circuit" by E. L. Carter and H. T. Ward published August 1981, Vol. 24, No. 3, pp.1705-1706 providing for a customized cascode current switch circuit which facilitates parity generation with fewer logic stages than conventional circuits.

The primary objective of the present invention is to overcome inherent limitations due to use of the implementations of CMOS logic circuits known heretofore which lead to increased layout area and decreased performance potential.

In accordance with the present invention, the class of logic known as Differential Cascode Current Switch (DCCS) logic can be mapped into Complementary Metal Oxide Semiconductor (CMOS) technology by replacement of the output load resistors with appropriately connected P channel Field Effect Transistor (FET) devices and the NPN logic transistors can be directly replaced with N channel Field Effect Transistors.

For a better understanding of the present invention, together with other and further advantages and features thereof, reference is made to the description taken in connection with the accompanying drawings, wherein :

Fig. 1A is a diagram showing the interconnection of the P devices in the CMOS implementation of the differential logic.

Fig. 1B is an analogous PNP interconnection as an enhancement to conventional differential cascode current switch.

Fig. 2 is a schematic diagram of the conventional implementations of CMOS logic showing the transmission functions.

Fig. 3 is a standard logic illustration of the previously derived logic function.

Fig. 4 is a schematic representation of the logic function in conventional functional circuit implementation.

Fig. 5 is an intermediate construction of the same logic function.

Fig. 6 is an optimized implementation of the same logic function shown in Fig. 5.

The following abbreviations are occasionally used herein:

| Abbreviation | Definition |
| --- | --- |
| CVS/CVSL | Cascode Voltage Switch Logic |
| DCVS | Differential Cascode Voltage Switch |
| FET | Field Effect Transistor |
| IS | Current Source in ground Circuit Return |
| MOS | Metal Oxide Semiconductor |
| NMOS | N Channel MOS - Devices with the majority carriers being electrons |
| PMOS | P Channel MOS - Devices with the majority carriers being holes |
| CMOS | Complementary Metal Oxide Semi-Conductor - a manufacturing process technology wherein both NMOS and PMOS devices are fabricated on the same wafer simultaneously |
| Vcc | Collector Voltage - most positive circuit potential |
| Vdd | Drain Voltage - most positive circuit potential |

A design concept is described here which enables the mapping of Differential Cascode Current Switch (DCCS) logic directly into Complementary Metal Oxide Semiconductor (CMOS) in a manner that the circuits are greatly simplified from both the conventional CMOS approaches and known DCCS logic formats. In the use of this design concept, the requirement for input signal level translators is eliminated as well as the requirements for a current source in the ground return circuit.

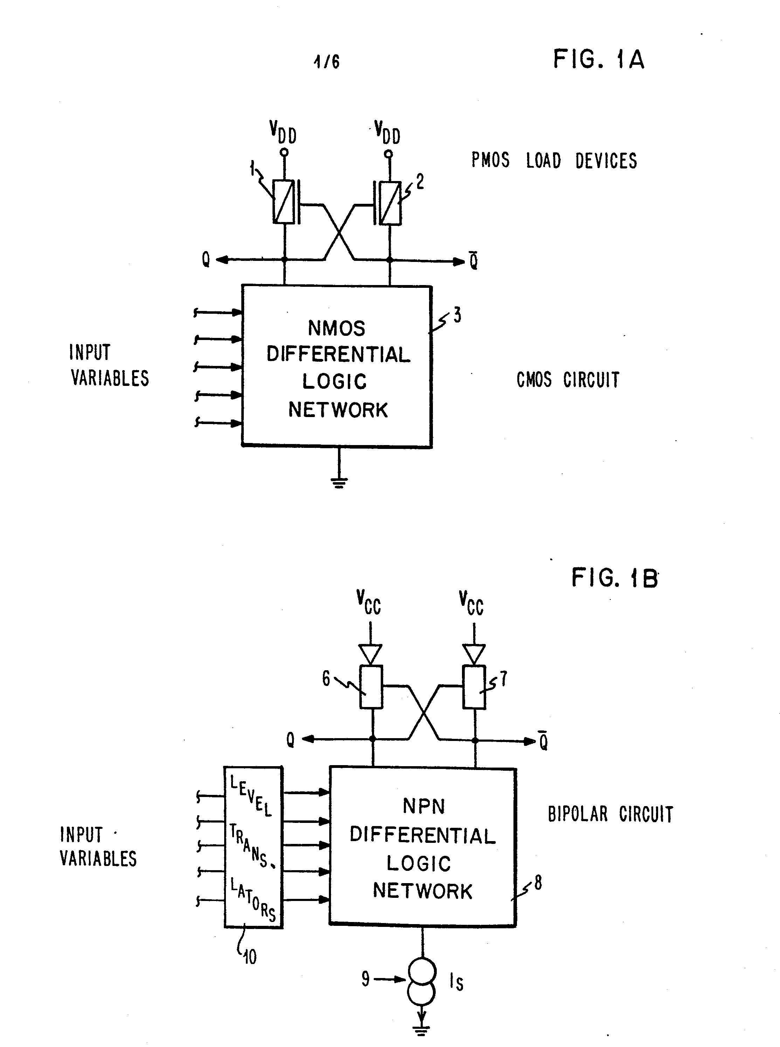

Fig. 1A shows a CMOS Differential Cascode Voltage Switch (DCVS) generalized circuit. It comprises PMOS channel load devices 1 and 2 and NMOS differential logic network block 3. The NMOS differential logic network has the attribute that the output nodes Q and $\bar{Q}$ are of opposite polarity. As an example, if Q is of a positive potential, then $\bar{Q}$ is a negative potential. It can be seen that if Q is a positive potential, for example, then P channel device 2 is rendered non-conducting and simultaneously $\bar{Q}$ will be at a low potential and P channel device 1 will be rendered conducting.

Fig. 1B shows a differential cascode current switch logic circuit comprised of PNP transistors 6 and 7 and NPN differential logic network block 8, a ground return current source 9 and input level translator block 10. The operation of the circuit is totally analogous to the operation of the circuit shown in Fig. 1A.

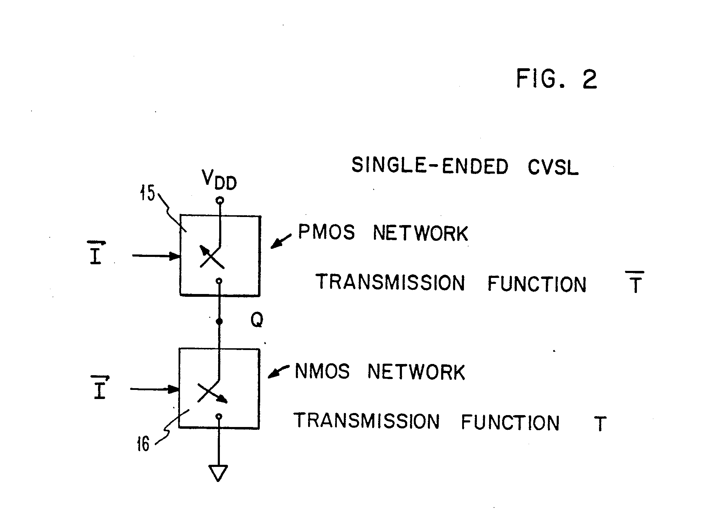

Fig. 2 shows a diagram comprised of PMOS logic network 15 and NMOS logic network 16 with inputs I. The PMOS network and the NMOS network are duals of each other in that when the PMOS network is rendered conductive, the NMOS network is non-conductive. The primary advantage of CMOS implementation of logic is that there is always the ability to come up with dual networks and since one is conducting and the other is not conducting there is no static DC power dissipated in the network.

For sake of example, Q can be defined by the boolean function

$$Q = \bar{A}\ \bar{B}\ \bar{C}\ \bar{D}\ +\ \bar{A}\ (B + C + D)$$

The logic trugh table for this function is as follows :

| CD \ AB | 00 | 01 | 11 | 10 |
|---------|----|----|----|----|
| 00 | 0 | 1 | 0 | 1 |
| 01 | 1 | 1 | 0 | 0 |
| 11 | 1 | 1 | 0 | 0 |
| 10 | 1 | 1 | 0 | 0 |

The boolean expression in MOS are
in PMOS

$$F_p = \bar{A}\ B\ C\ D + A\ (\bar{B} + \bar{C} + \bar{D})$$

in NMOS

$$F_n = \bar{A}\ \bar{B}\ \bar{C}\ \bar{D}\ + A\ (B + C + D)$$

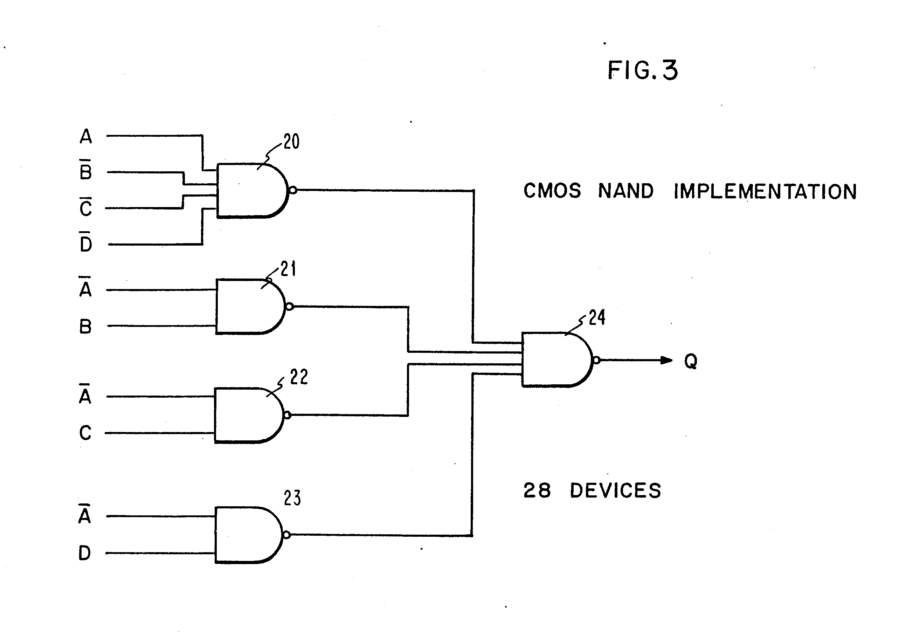

Fig. 3 is a diagram showing a NAND implementation of the arbitrary boolean logic function taken as example. The individual elements are computed by blocks 20-24 to give the resultant output Q. The network consists of 28 devices when drawn in a schematic form. There are two devices per input variable in blocks 20-24 and since there are instances of 10 input variables and 4 intermediate variables, the resultant sum equal 28.

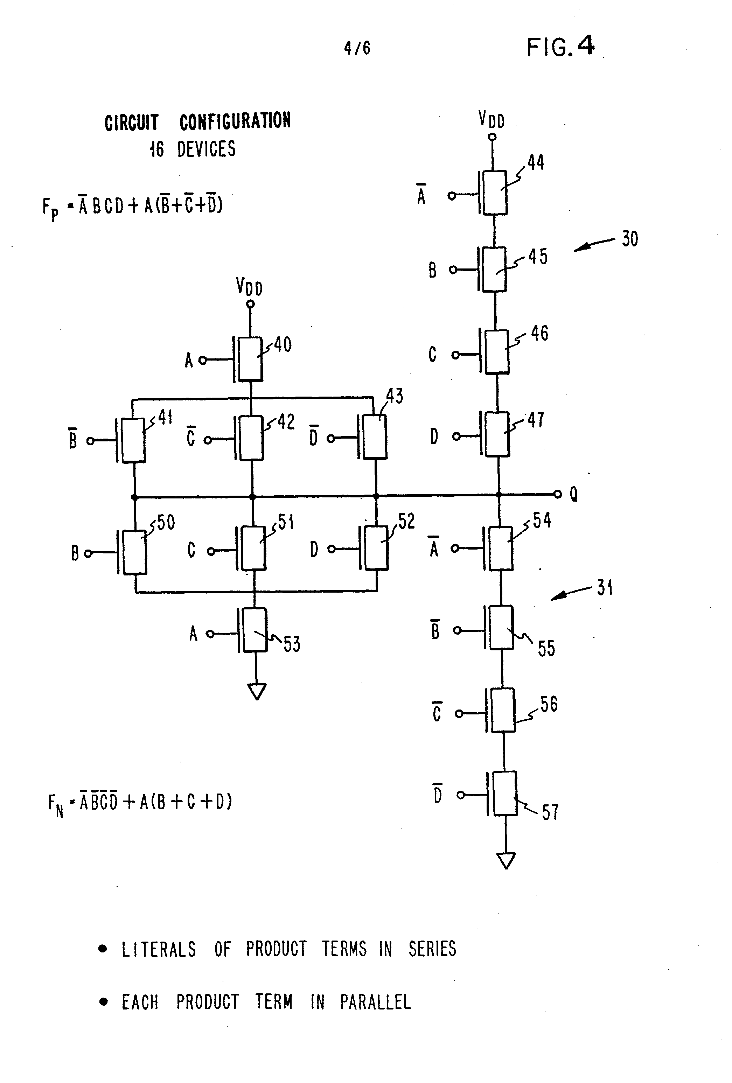

Fig. 4 consists of a schematic diagram of a high level functional implementation of the previously defined boolean functional example. It comprises two sections 30 consisting of P channel devices and 31 consisting of N channel devices. The P channel devices 40-47 are the dual of the network of the N channel devices 50-57.

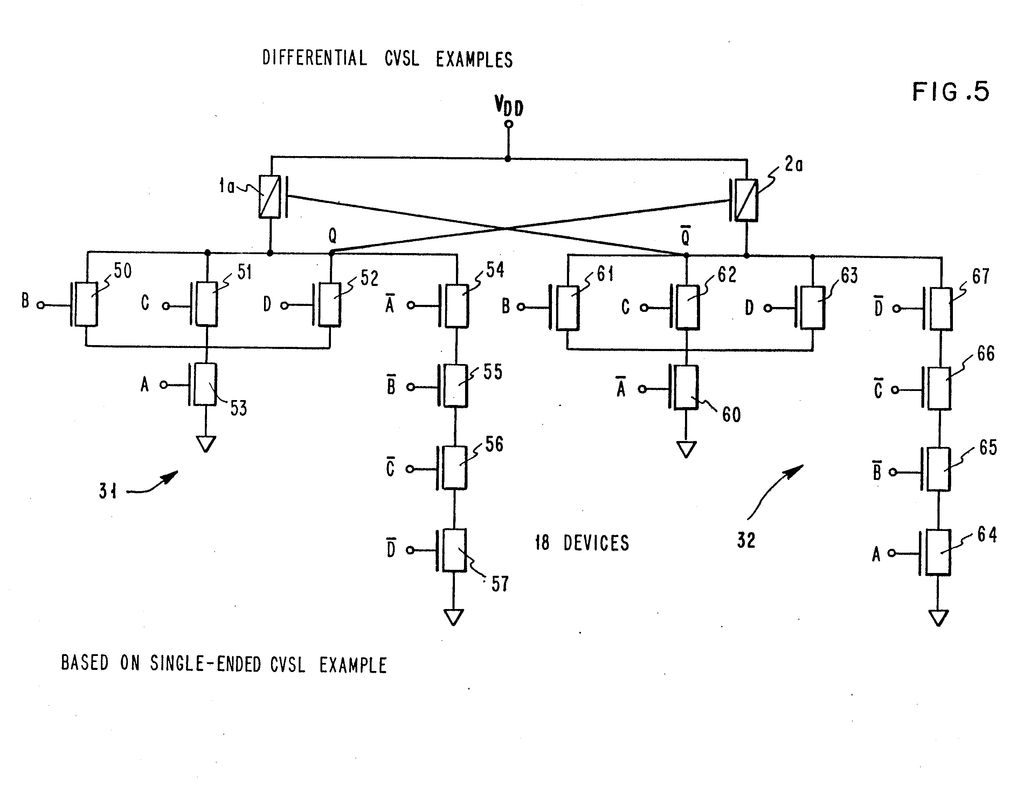

Fig. 5 shows a differential CVSL implementation according to the of the network shown previously in Fig. 4. The implementation comprises the previously section 31 with N channel devices 50-57. The section 30 with P channel devices of Fig. 4, 40-47, is replaced by section 32 changed in polarity from P channel to N channel devices now designated 60-67. The input variables of Fig. 4 section reference 30 are complemented in nature so that the network 60-67 remains the functional dual of network Fig. 4 31, 50-57. In addition, there are 2 P channel devices, 1a, 2a analagous to devices 1 and 2 in Fig. 1A. It can be seen that the device count of the implementation of the example in Fig. 5 is the same as the example in Fig. 4 for the logic devices and there are two devices added for a total of 18 devices. This remapping of the implementation in Fig. 4 to the differential form in Fig. 5 achieves the Q and $\bar{Q}$ outputs to give the appropriate drive to the load devices.

Even though this simple remapping of the logic has two additional devices to realize the boolean function, it has significant electrical advantages in that the low gain P polarity devices are not connected in a series connection that leads to additional reduction in gain due to a reduction in effective electrical width as a result of this series connection. Furthermore, there is no electrical P device threshold modulation due to backgate effects, since the sources of 1A, 2A are always connected to the most positive circuit potential, preserving the threshold of 1A, 2A at a value fixed by process and device constants. Thirdly, the input capacitance that has to be driven by the input signal sources is reduced below that of the example shown in Fig. 4 because the resultant total input capacitance for each input is lessened due to the fact that the individual gate areas of the logic devices in the dual network may be decreased in inverse proportion to the difference in the N device gain over the P device gain due to superior electrical majority carrier mobility in the N polarity devices.

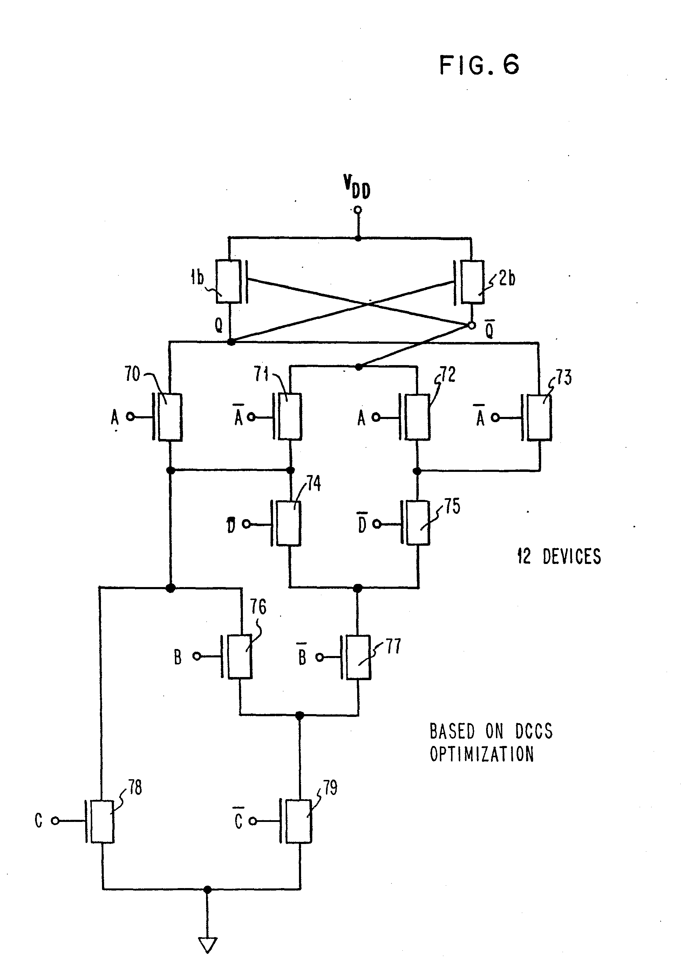

Fig. 6 shows an optimized version of the implementation of Fig. 5 wherein the redundant devices are removed and the intermediate nodes are optimally connected. In this optimization, transistors 50-57 and 60-67 of Fig. 5 are replaced by transistors 70-79 in Fig. 6. The total device count to do the same function is reduced from 18 devices to 12 devices. This ratio is of course, a function of the boolean equation that is computed and does not necessarily hold true in all cases. However, similar advantages are achieved in all cases seen to date.

This reduction in total device count has the important result of occupying less circuit layout area, increasing the total function that may be inplemented in a given area. This benefit may be utilized either by holding function fixed and reducing the total area required, or adding more function to the given implementation area.

The following table illustrates the savings in devices realized by utilization of the optimized differential cascode voltage switch logic described herein:

POTENTIAL LEVERAGE AT THE CIRCUIT/MACRO LEVEL

DEVICES

| | |
|---|---|
| Conventional Functional Single-Ended CVSL (Fig. 4) | 16 |
| Simple Diff. CVSL (Fig. 5) | 18 |
| Optimized Diff. CVSL (Fig. 6) | 12 |
| CMOS NANDS (Fig. 3) | 28 |

Thus a significant aspect of this invention is a discovery that differential cascode voltage switch can optimally compute boolean functions with fewer devices than conventional

0130363

implementations such as that shown in Fig. 4 with the added advantage in that both polarities, the Q and Q̄ outputs are available for subsequent computation. Implicit in diagrams such as Fig. 4 is the not input variables have to be generated by off circuit inverters which actually in most cases will add significant circuit complexity and increase device count.

While a preferred embodiment of the invention has been illustrated and described, it is to be understood that there is no intention to limit the invention to the precise construction herein disclosed and the right is reserved to all changes and modifications coming within the scope of the invention as defined in the appended claims.

0130363

CLAIMS

1.  A  differential  logic  circuit  with  efficient  load
characteristics characterized in that it comprises :

first and second channel load devices (1b, 2b) having a
first polarity characteristic;

first (31) and second (32) differential logic channel
networks each comprising a plurality of channel devices
(50-57 or 60-67) having a second polarity characteristic,
the devices in one of said networks being provided in
lieu of a corresponding plurality of devices having said
first polarity characteristic;

a  plurality  of  voltage  sources  (VDD)  for  supplying
operating  potentials  to  said  load  devices  and  said
channel devices;

means interconnecting said first and second channel load
devices  respectively  to  said  first  and  second  channel
networks and for logically cross-coupling said first and
second channel networks respectively to said second and
first channel load devices; and

input variable means for supplying input signals on an
individual basis to the channel devices in said first and
second channel networks.

2.  The logic circuit of Claim 1 wherein said channel devices
in said first and second channel networks are selectively
interconnected in an optimized manner in order to reduce
the total number of channel devices needed for functions
required in said logic circuit.

3.  The circuit according to claim 1 wherein said first (1a)
and  second  (2a)  channel  load  devices  are  of  the  P

0130363

polarity and said channel devices (50-57 or 60-67) of said logic channel networks are of the N polarity.

4.  A differential logic circuit with efficient load characteristics for use with NPN bipolar devices, comprising:

a first PNP load device;

a second PNP load device;

a first NPN differential logic network comprising a plurality of NPN devices;

a second NPN differential logic network comprising a plurality of NPN devices, said NPN devices in said second network being provided in lieu of a corresponding plurality of PNP devices;

a plurality of voltage sources for supplying operating potentials to said devices;

means interconnecting said first and second PNP load devices respectively to said first and second NPN networks and for logically cross-coupling said first and second NPN networks respectively to said second and first PNP load devices;

input variable means for supplying input signals on an individual basis to the NPN devices in said first and second NPN networks; and

level translators interposed between said input variable means and said NPN devices for converting voltage levels of said input signals to voltage levels suitable for operating said NPN devices.

1/6  FIG. 1A

V_DD   V_DD   PMOS LOAD DEVICES

1   2

Q   $\bar{Q}$

INPUT VARIABLES

NMOS DIFFERENTIAL LOGIC NETWORK   3

CMOS CIRCUIT

FIG. 1B

V_CC   V_CC

6   7

Q   $\bar{Q}$

INPUT VARIABLES

LEVEL TRANS. LATORS   10

NPN DIFFERENTIAL LOGIC NETWORK   8

BIPOLAR CIRCUIT

9 → Is

FIG. 2

SINGLE-ENDED CVSL

$V_{DD}$

15

$\overline{I}$ →

PMOS NETWORK

TRANSMISSION FUNCTION $\overline{T}$

Q

$\overline{I}$ →

NMOS NETWORK

TRANSMISSION FUNCTION T

16

## FIG.3

CMOS NAND IMPLEMENTATION

28 DEVICES

0130363

FIG. 4

CIRCUIT CONFIGURATION
16 DEVICES

$F_P = \overline{A} BCD + A(\overline{B} + \overline{C} + \overline{D})$

$F_N = \overline{A}\,\overline{B}\,\overline{C}\,\overline{D} + A(B + C + D)$

- LITERALS OF PRODUCT TERMS IN SERIES

- EACH PRODUCT TERM IN PARALLEL

DIFFERENTIAL CVSL EXAMPLES

FIG.5

18 DEVICES

BASED ON SINGLE-ENDED CVSL EXAMPLE

0130363

FIG. 6

$V_{DD}$

1b    2b

Q    $\overline{Q}$

70    71    72    73

A    $\overline{A}$    A    $\overline{A}$

74    75

$\overline{D}$    $\overline{D}$

12 DEVICES

76    77

B    $\overline{B}$

BASED ON DCCS
OPTIMIZATION

78    79

C    $\overline{C}$